Europäisches Patentamt

European Patent Office

Office européen des brevets

(19)

(11) **EP 0 674 798 B1**

(12) **EUROPEAN PATENT SPECIFICATION**

(45) Date of publication and mention
of the grant of the patent:
**06.05.1999 Bulletin 1999/18**

(21) Application number: **94902891.4**

(22) Date of filing: **17.12.1993**

(51) Int Cl.6: **G11C 11/404**, G11C 11/44

(86) International application number:
**PCT/GB93/02581**

(87) International publication number:
**WO 94/15340 (07.07.1994 Gazette 1994/15)**

(54) **MEMORY DEVICE**

SPEICHERANORDNUNG

DISPOSITIF A MEMOIRE

(84) Designated Contracting States:
**DE FR GB NL**

(30) Priority: **18.12.1992 GB 9226382**

(43) Date of publication of application:
**04.10.1995 Bulletin 1995/40**

(73) Proprietor: **HITACHI EUROPE LIMITED
Maidenhead, Berkshire, SL6 8YA (GB)**

(72) Inventors:
 • **NAKAZATO, Kazuo
 Cambridge CB1 4PA (GB)**
 • **AHMED, Haroon
 Cambridge CB3 9HP (GB)**

(74) Representative: **Read, Matthew Charles et al
Venner Shipley & Co.
20 Little Britain
London EC1A 7DH (GB)**

(56) References cited:
**GB-A- 2 256 313        US-A- 3 259 759
US-A- 3 643 237        US-A- 3 882 472
US-A- 3 986 180        US-A- 4 103 312**

 • **ELECTRONIVS LETTERS vol. 29, no. 4 , 18
 February 1993 pages 384 - 385 NAKAZATO ET
 AL 'SINGLE -ELECTRON MEMORY'**

## Description

This invention relates to a memory device.

Semiconductor memory devices are becoming smaller, with a consequent reduction in power consumption per bit. However, the size reduction results in a decrease in the number of electrons at each storage node and the statistical fluctuation in the number of electrons becomes large so that the electrons cannot be controlled by conventional methods.

For a nanofabricated structure, if one electron is added to a nanofabricated island, the charging energy will increase. Consequently, an electron cannot enter the island when the charging energy is larger than the thermal energy. This is known as Coulomb Blockade.

Coulomb Blockade was described by Gorter, C.J., Physica, 17, pp 777 - 780 (1951) in relation to charge carrier transport through films of oxidised metal grains. However, Coulomb Blockade has attracted much interest recently when it was demonstrated that a single electron transistor could be produced [Fulton, T. A. and Dolan G.J.: "Observation of Single-Electron Charging Effects in Small Tunnel Junctions", Phys. Res. Lett., 1987, 59, pp 109 - 112].

A turnstile based on Coulomb Blockade, for the transfer of individual electrons has recently been demonstrated [Geerligs, L.J Anderegg, V.F., Holweg, P.A.M., Mooij, J.E., Pothier, H., Esteve, D., Urbina, C., and Devoret, M.H.,: "Frequency- Locked Turnstile Device for Single Electrons", Phys. Rev. Lett., 1990, 64 pp 2691-2694]. The turnstile consists of a linear array of tunnel junctions along which electrons tunnel from an input, through a first pair of tunnel junctions to a node, and then from the node through a second pair of tunnel junctions to an output. Control voltages are applied to the input, the output, and to the node through a capacitor, at MHz frequencies in order to clock electrons individually through the array. During operation, the node changes between different electron states as individual electrons enter and leave the node.

Also, reference is directed to Averin, D.V., and Likharev, K.K.: "Single electronics: A Correlated Transfer of Single Electrons and Cooper Pairs in Systems of Small Tunnel Junctions", in B.L. Altshuler, P.A. Lee, and R.A. Webb (Ed); "Mesoscopic Phenomena in Solids", (Elsevier, Amsterdam, 1991), pp 173 - 271.

In our EP-A-0562751, there is described a device in which a plurality of storage nodes are provided which exhibit first and second stable storage states, in which electron transport to each node is through series connected tunnel junction devices and limited by Coulomb Blockade. A clocking system is provided to control the switching between electron states at each node. The concept of bistable or internal memory at a node, achieved by a series connected capacitance and a series of tunnel junctions or a multiple tunnel junction device is discussed in Averin, D.V.,and Likharev, K.K.: "Possible Applications of Single Charge Tunnelling" in H. Grabert and M.H. Devoret: "Single Charge Tunnelling" (Plenum Press, New York, 1992) pp 311-332.

It is an object of the present invention to provide a memory cell that uses Coulomb Blockade to control the electron number at the node, which can be controllably and reliably shifted between stable electron storage states, and which can form a building block for arrays of such cells, which can be addressed individually.

According to the invention from a first aspect, there is provided a memory device including a memory cell that comprises: a memory node for storing charge; barrier means for providing a tunnel barrier configuration having a threshold for charge carrier tunnelling, in a region coupled to the memory node in such a manner that the memory node exhibits first and second quantised memory states for which the level of stored charge is limited by Coulomb Blockade; a side gate to produce a field in said region that controls the threshold of the tunnel barrier configuration therein for controlling charge carrier tunnelling through the tunnel barrier configuration to produce a transition between the quantised states at the memory node.

The device may include capacitor means coupled to the memory node, and a variable voltage may be applied across the capacitor means and the tunnel barrier configuration for controlling the probability of charge tunneling though the barrier means to produce said transition between the quantised states at the node.

The field produced by the side gate may be varied so as to control the probability of charge tunnelling through the barrier means to produce said transition between quantised states at the node.

The cell conveniently includes an output means for example an electrometer for providing a logical output signal in response to the memory state of the memory node.

The invention also includes a plurality of the memory cells arranged in an array, and in accordance with the invention, the cells may be separably addressable for writing data to, or reading data from each cell individually.

In a second aspect, to provide individual cell addressability, the invention provides a memory device including a memory cell that comprises: a memory node for storing charge; means for providing a multiple tunnel barrier configuration for charge carriers, coupled to the memory node, in such a manner that the node exhibits first and second quantised memory states, with the voltage level at the node being limited by Coulomb Blockade to a threshold voltage; and control means for controlling charge carrier tunnelling through the tunnel barrier configuration to produce a transition between the quantised states at the node, said control means including first and second means for selectively applying respective control potentials to the node of the cell, the node being switched between said first and second quantized states in response to predetermined combinations of said control potentials which exceed the threshold voltage.

The or each memory cell can be formed by selectively etching a δ-doped layer that forms an essentially two dimensional conductive layer, although other tunnel junction configurations can be used.

Further features and advantages of the invention will be apparent from the following description of examples thereof and the accompanying drawings in which:

FIGURE 1 is a schematic circuit diagram of a nanofabricated memory cell connected to an electrometer, in accordance with the invention;

FIGURE 2 is a graph illustrating the principle of operation of the device shown in Figure 1 wherein the voltage on the memory node of the memory cell is plotted as a function of gate voltage, for cyclic operation with n electrons on the memory node;

FIGURE 3 is a schematic illustration of the structure of MTJ1 of Figure 1;

FIGURE 4 is a bird's eye view (derived from a scanning electron micrograph) of a practical arrangement corresponding to the circuit of Figure 1;

FIGURE 5 illustrates graphs of memory operation characteristics of the device, showing hysteresis;

FIGURE 6 illustrates an array of memory cells arranged in row and columns;

FIGURE 7a illustrates the source/drain voltage versus current characteristic for the multiple tunnel junction device shown in FIGURE 7b;

FIGURE 8a is a graph of the memory node voltage $V$ as a function of the gate voltage $V_g$ for a high value of the Coulomb Blockade threshold limit $V_{Ch}$ when a write pulse $B_W$ is applied to the cell, to show that no data is written;

FIGURE 8b corresponds to Figure 8a, but with a lower Coulomb Blockade threshold limit $V_{Cl}$, for demonstrating that data is written into the cell in response to write pulse $B_W$;

FIGURE 9 illustrates positive and negative going write pulses $\pm B_W$ (max);

FIGURE 10 illustrates an alternative memory cell array;

FIGURE 11 illustrates yet a further memory cell array, with a common output electrometer for each column;

FIGURE 12 is a partial schematic diagram of a further version of the memory cell in which a fixed side gate voltage is applied to MTJ1;

FIGURE 13 is a graph of memory node voltage $V$ versus applied gate voltage $V_g$ to illustrate writing of date in the cell of Figure 12;

FIGURE 14 is a schematic circuit diagram of part of yet another version of the memory cell;

FIGURE 15 illustrates the writing of binary data 1 into the memory cell of Figure 14;

FIGURE 16 is a circuit diagram of yet another modification to the memory cell;

FIGURE 17 illustrates a memory cell in which the electrometer is replaced by a field effect transistor (FET);

FIGURE 18 illustrates an alternative form of the δ-doped layer with a gate formed in the substrate;

FIGURE 19 is a schematic perspective view of another form of multiple tunnel junction device, formed on a silicon substrate;

FIGURE 20 is a longitudinal section through the device of Figure 19;

FIGURE 21 corresponds to Figure 20 illustrating a modification;

FIGURE 22 illustrates a further form of multiple tunnel junction device, which comprises a modification of the arrangement shown in Figure 19;

FIGURE 23 is a section through the device of Figure 22;

FIGURE 24 is a section, corresponding to Figure 23, showing a modification;

FIGURE 25 illustrates a further version of a silicon-implemented multiple tunnel junction device;

FIGURE 26 is a section through the device of Figure 25;

FIGURE 27 is a section, corresponding to Figure 26, illustrating a modification;

FIGURES 28a-d illustrate plan views from the bottom to top layer of an example of a memory cell in accordance with the invention, which uses a planar multiple tunnel junction device;

FIGURE 28e is a sectional view along I-I' shown in Figure 28d;

FIGURE 29 corresponds to Figure 28, but shows a vertically structured multiple tunnel junction device; and

FIGURE 30 is a graph of the storage time versus electron state characteristics of the memory node shown in Figure 4.

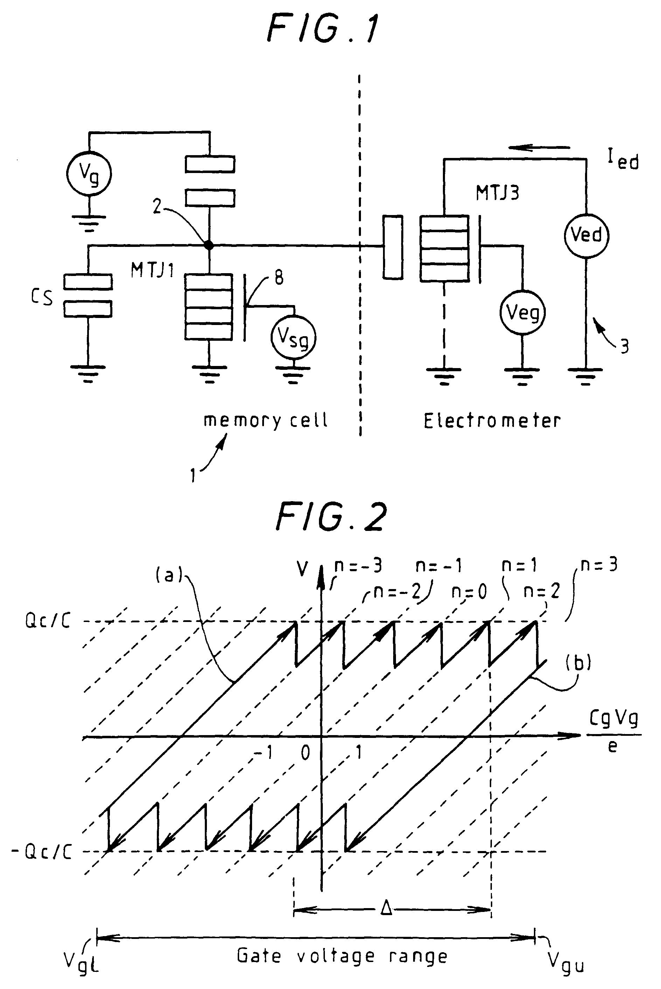

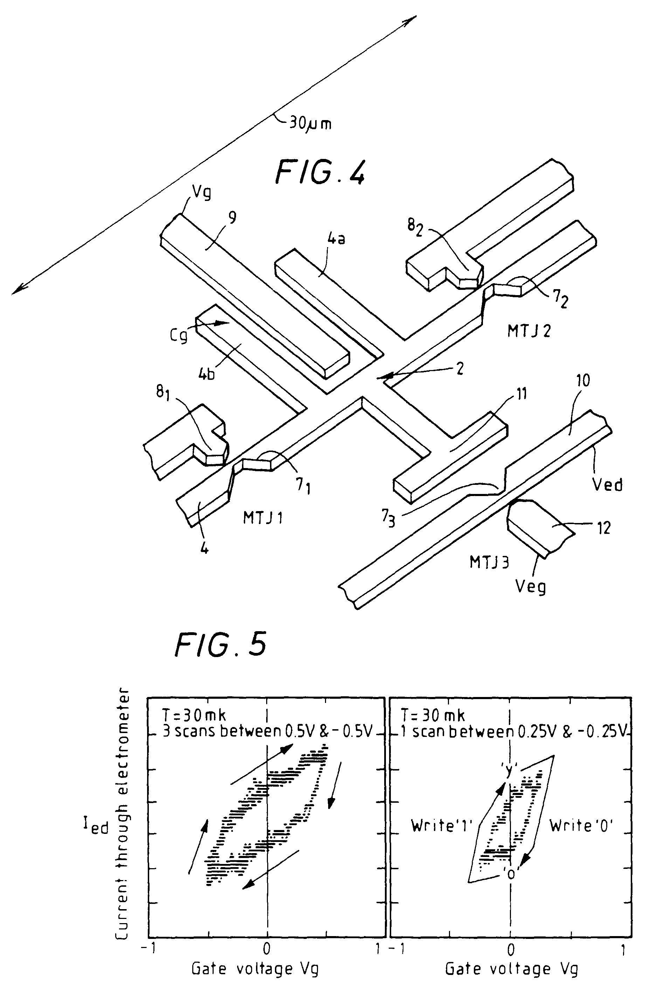

Referring to Figure 1, a memory device in accordance with the invention includes a memory cell 1 with a memory node 2. The voltage $V$ of the memory node 2 is detected by an electrometer 3.

The memory cell 1 includes a side gated multiple tunnel junction device MTJ1 in series with a gate capacitor $C_g$, connected to a source of gate voltage $V_g$. The side gate of MTJ1 is connected to a source of side gate voltage $V_{sg}$. The voltage $V$ at the memory node 2 depends both on the voltage $V_g$ applied to the gate capacitor and also the charge stored on the node 2. Electron transfer to and from the node 2 is possible only through the multiple tunnelling junction MTJ1. As will be explained in more detail hereinafter, a multiple tunnel junction device can be considered as a number of series connected tunnelling junctions. As used herein, the term multiple tunnel junction device (MTJ) means a device with more than two series connected tunnelling junctions and the passage of single electrons through MTJ1 is prevented by Coulomb Blockade when the modulus of the charge IQI on one side of this device is less than a critical charge Q i.e. when $-Q_c < Q < Q_c$ where the critical charge is given by

$$Qc = \frac{eC}{\Sigma C} \frac{(1+\Delta)}{2} \qquad (1)$$

Here $\Sigma C$ is the total capacitance $C + C_g + C_s$, where C is the capacitance of the MTJ1, $C_g$ is the gate capacitance, and $C_s$ is the stray capacitance; $\Delta$ determines a multi-state condition given by

$$\Delta = \frac{(N-1)}{N} \frac{(C_g + C_s)}{C} \qquad (2)$$

where N is the number of tunnel junctions in MTJ1. The voltage V at the memory node is given by

$$V = \frac{e}{\Sigma C} \left( \frac{C_g V_g}{e} - n \right) \qquad (3)$$

where n is the number of excess electrons on the node.

Equation (3) is plotted in Figure 2 and consists of a series of parallel lines for different values of n, shown in dotted outline. Within a Coulomb Blockade regime, $-Q_c/C < V < Q_c/C$, electrons cannot enter or exit the memory node 2 and the upper and lower limits of the voltage V of the memory node 2 that are set by Coulomb Blockade, $\pm Q_c/C$, are shown by chain lines in Figure 2. When V reaches the boundary of this Coulomb Blockade regime, one electron enters or leaves to keep the energy of the node 2 inside the Coulomb Blockage regime. By applying a gate-voltage pulse $V_g$ with magnitude larger than $e\Delta/Cg$, the number of electrons on the memory node can be changed as will be explained in more detail hereinafter.

The resulting characteristic exhibits hysteresis and is represented by the solid line shown in Figure 2. Considering when the gate voltage is increased from the lowest value $V_{gl}$ of the range shown in Figure 2, the characteristic moves along line (a) for which n=-3 (a shortfall of 3 electrons at the node 2) until the memory node voltage reaches the Coulomb Blockade limit $Q_c/C$. The node 2 then gains an electron by virtue of the Coulomb Blockade effect, so the characteristic jumps to the line for n=-2, since the node voltage V is limited by Coulomb Blockade. As the gate voltage is progressively increased to $V_{gu}$, its upper value, the electron state of the memory node progressively increases stepwise until a surplus of 3 electrons becomes established on the node 2, i.e. n= 3. If the gate voltage $V_g$ is then decreased, the voltage at memory node 2 decreases along line (b) for n= 3, until the lower Coulomb Blockade limit $-Q_c/C$ is reached, whereafter the electron state of the node changes stepwise to n=-3 as the gate voltage is reduced to its lower limit $V_{gl}$.

When the gate voltage $V_g$ is at zero, the node 2 can thus assume one of two stable states, for which, as shown in Figure 2, in this example, n=±2, and this can be used as a memory.

In general, one bit of information can be represented by + n and - n electron number states, where n is given by the integer part of $(\Delta+1)/2$. If the capacitances are chosen to satisfy the condition $\Delta<1$, a binary code can be represented by the presence or absence of one electron.

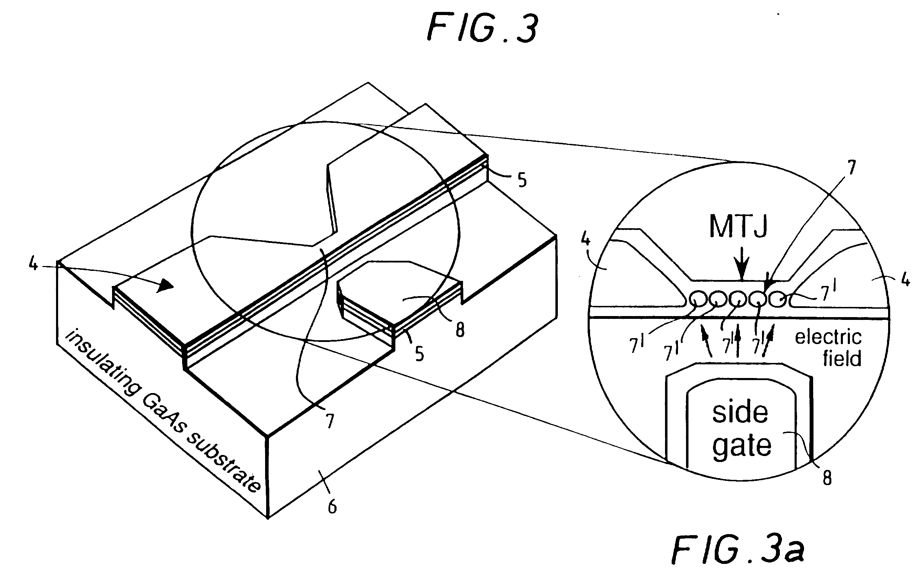

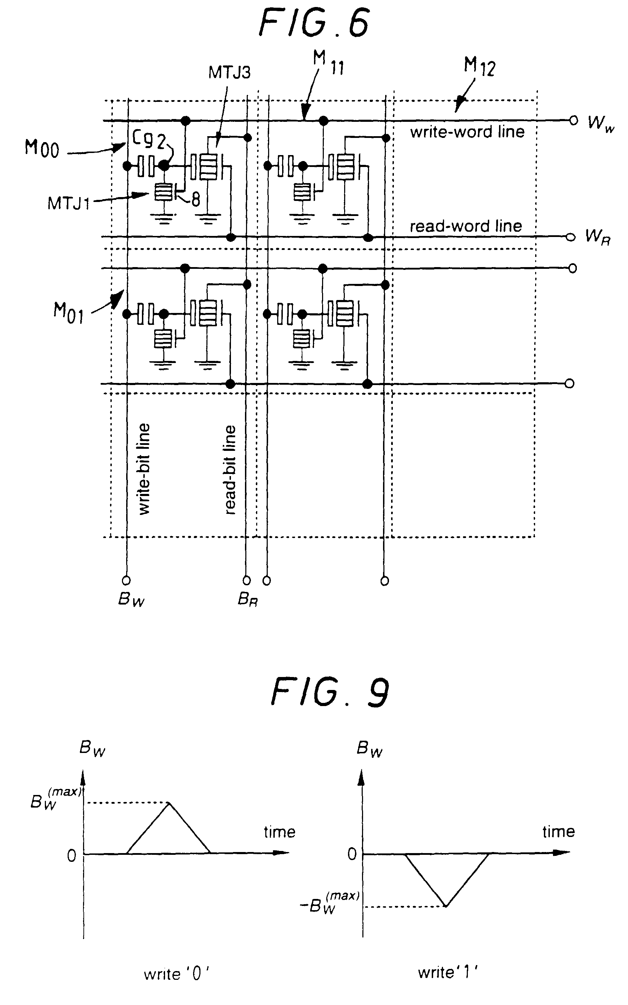

A practical form of the memory cell 1 will now be described with reference to Figure 4. In order to utilise the Coulomb Blockade effect, the structures must be made sufficiently small to make the charging energy larger than the thermal energy; the charging energy is proportional roughly inversely to the linear dimension. To realise a suitable very small structure, a side-gate structure in $\delta$-doped GaAs material may be used, as shown in Figure 3. An elongate electron channel 4 is formed in a $\delta$-doped layer 5 which is situated 30 nm below the surface of a GaAs substrate 6 and is a few atomic layers in thickness. The layer 5 is typically doped with Si to a concentration of $5 \times 10^{12}$ cm$^{-2}$ and the various layers are grown by MBE or MOCVD techniques. In both processes, the thickness of the dopant layer can be introduced into only one atomic layer, and the resulting material is said to be $\delta$-doped. Nakazato, K., Thornton, T.J., White, J., and Ahmed, H.: "Single-electron effects in a point contact using a side-gating in delta-doped layers", Appl. Phys. Lett., 1992, 61, 3145. A fine side-gated constriction 7 with a spaced side gate 8 is defined by electron beam lithography and wet etching to a depth of 120nm to form the junction MTJ1. The resistance of the junction is controllable since the application of a negative voltage to the side gate 8 changes the electron Fermi energy and repels the electrons from the edge of the electron channel.

As a specific example of the process parameters, the MTJ was formed by an etched constriction with a mask width of 500nm and length of 200 nm. The mask width at the narrowest part (i.e. side-gate to channel separation) was 300 nm. The pattern was defined by electron beam (EB) lithography and wet-etching. The EB exposure was performed on a 150 nm thick polymethylmetacrylate (PMMA) coated on the $\delta$-doped GaAs wafer. After exposure, a 30 sec development process with a weak developer (methyl-isobutyl-ketone : isopropylalcohol = 1:5) was made in order to develop only the strongly exposed regions. After 20 sec O$_2$ plasma etch to remove residual resist, the $\delta$-doped GaAs layers were etched using an H$_3$PO$_4$ : H$_2$O$_2$ : H$_2$O = 1:2 : 40 solution. The depth of the trench was controlled to 120 nm by adjusting the etch-time.

Figure 3a is a schematic enlarged view of the constriction 7 of the MTJ shown in Figure 3. It has been found that the characteristics of the MTJ can be explained by considering the conductive channel 4, in the region of the constriction 7, to comprise a plurality of conductive islands 7', between which electrons can tunnel, with the charge of the individual islands being limited by Coulomb Blockade. It can be shown that the sum of the effects of the individual islands 7' gives rise to a multiple tunnel junction. It is postulated that the tunnel barriers between the individual islands are produced by channel impurities.

The same fabrication process can be used to produce the Coulomb Blockade electrometer 3 that detects the voltage on the memory node 2, as will become apparent from the following description of Figure 4.

In Figure 4, a scanning electron micrograph of a single-electron memory device corresponding to Figure 1, is shown. All of the components are formed by etching a $\delta$-doped substrate according to the principles previously described. The dimensions of the configuration shown in Figure 4 are typically 30 x 30μm. The memory cell 1 incorporates two multiple tunnel junctions MTJ1, MTJ2, fabricated as previously described, connected in series each with a respective constriction $7_1$, $7_2$ and side gate $8_1$, $8_2$. The additional junction MTJ2 is for calibrating MTJ1, as will be described later.

The memory node 2 is provided at the series connection between the junctions MTJ1 and MTJ2 in the channel 4. The gate voltage is applied on channel 9 which cooperates with channel extensions 4a, b in the region of the memory node 2, to define the gate capacitor $C_g$. The electrometer MTJ3 includes a multi-tunnel junction fabricated in the same way as MTJ1 and MTJ2, with a source/drain channel 10 formed from the $\delta$-doped layer, including a constriction $7_3$ having two associated side gates 11, 12. The gate 11 controls the source/drain current in the channel 10 as a function of the voltage V of the memory node 2. The gate 12 permits a bias voltage $V_{eg}$ to be applied so that the electrometer can be biased to a linear operating region, such that the source-drain/current $I_{ed}$ increases linearly with an increase in the node voltage V.

By applying a side-gate voltage to the side gate $8_1$ to make the resistance of MTJ2 low, the characteristics of MTJ1 can be measured for calibration purposes - see Nakazato et al - supra. After such characterisation, MTJ2 is cut-off by applying a large negative voltage to its side gate $8_2$. In a specific example, the voltages applied to the gate $8_1$, $8_2$, of MTJ1 and MTJ2 are $V_{sg1}$ = -2 → -4V and $V_{sg2}$ = - 3.5V (which produced cut-off). For electrometer MTJ3, suitable voltages are $V_{ed}$ = 20 mv and $V_{eg} \approx$ 1.3 - 2V, to produce a linear response in which the source/drain current $I_{ed}$ typically ranges over 5-20 nA, in response to changes in the voltage V of the memory node 2.

The memory cell characteristics may be investigated by varying the gate voltage $V_g$ and monitoring the electrometer current $I_{ed}$.

The memory cell characteristics are shown in Figure 5, for three cycles of $V_g$ between 0.5V and -0.5V and for one cycle between 0.25V and -0.25V. Clear and reproducible hysteresis was observed. Thus, by using the gate voltage $V_g$ as a write voltage, logic levels 1 and 0 can be written onto the memory node 2.

From a rough estimation of capacitance, C = 10aF, $C_g = C_s$ = 1fF by the previously mentioned characterisation of MTJ1, so it can be determined that the upper and the lower branches of the graphs shown in Figure 5 at zero gate voltage $V_g = 0$ correspond to ± 100 electrons. A step-like characteristic in the measured curves indicates the entrance and exit of single electrons at the node 2.

Thus, a single-electron memory cell is provided using side-gated structures in a $\delta$-doped layer. In the experimental structure shown in Figure 4, one bit of information is represented by + n electron number states with n ≈100. It is possible to reduce the number of electrons and represent the binary code with a single electron, for example, by redesigning capacitor $C_g$. The number of electrons used has a bearing on the maximum storage time that can be achieved, as will be discussed hereinafter.

The described device operates at low temperatures, typically 1K. However, if the structure is made at a scale of less than 5nm, the memory is operable at room temperature.

Examples of arrays of memory cells in accordance with the invention will now be described, in which the cells can be addressed individually for reading and writing operations. In the example of the invention shown in the preceding Figures, the memory node 2 is switchable between its two memory states by varying the gate voltage $V_g$. However, it is also possible to switch the memory node by use of the side gate voltage $V_{sg}$ or a combination of the gate voltage $V_g$ and the voltage $V_{sg}$ applied to the side gate 8 of MTJ1.

An example of an array of memory cells that operates in this way, will be described with reference to Figure 6. The configuration comprises a rectangular array of memory cells $M_{nm}$, which in this example is shown schematically as a 3 x 3 array arranged in rows and columns. The cell $M_{00}$ will be considered in detail by way of example; all of the other memory cells are operated in the same way. The circuit of the cell $M_{00}$ is substantially the same as that described in reference to Figure 1 and comprises a memory node 2 with a gate capacitor $C_g$ and a multiple tunnel junction MTJ1 having a side gate 8. The voltage of the memory node 2 is detected by electrometer MTJ3.

Particular memory cells are selected on a row and column basis and thus memory cell $M_{00}$ is written with information by means of a write-word line $W_W$ that is connected to the side gates 8 of each memory cell in a particular row, and by means of a write-bit line $B_W$ connected to the gate capacitors $C_g$ of each memory cell in a particular column. Data is written into the memory node 2 of memory cells $M_{00}$ when a write pulse is applied concurrently to the write-bit line $B_W$ and the write-word line $W_W$ connected to the cell.

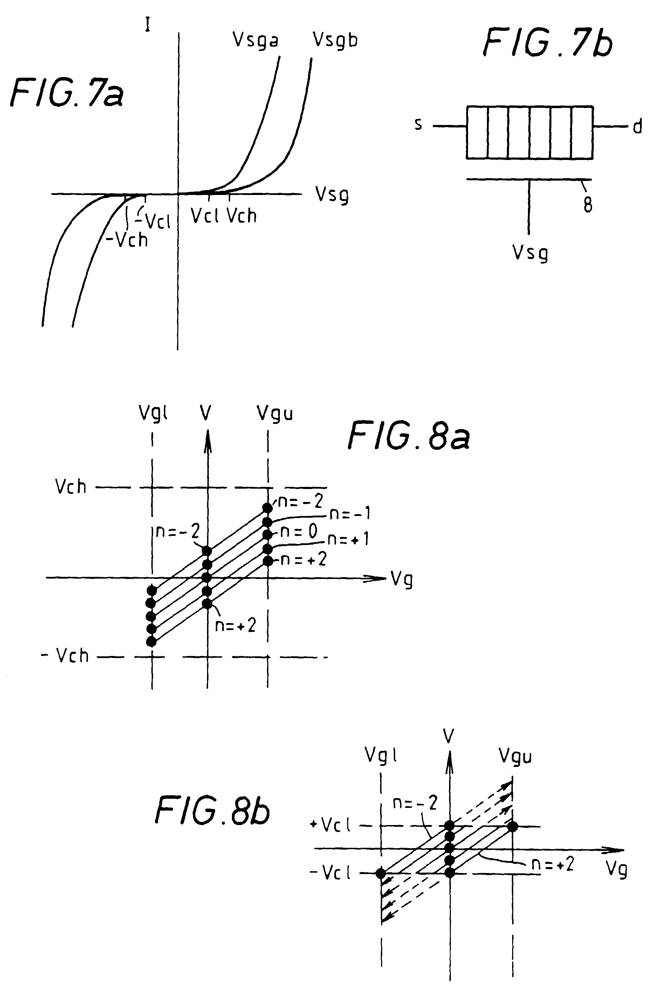

In order to explain the writing operation, reference will now be made to Figures 7 and 8. In Figure 7b, a MTJ is shown schematically comprising multiple tunnel junctions connected between a source s and a drain d, and having a side gate 8 that receives a side gate voltage $V_{sg}$. The source-drain voltage/current characteristic is shown in Figure 7a, for two different values of gate voltage $V_{sga}$, $V_{sgb}$. As previously explained, the multiple tunnel junction MTJ exhibits Coulomb Blockade such that for a range of voltages :

$$- Q_c/C < V < Q_c/C \qquad (4)$$

This can be restated as:

$$- V_c < V < V_c \qquad (5)$$

Referring to Figure 7a, it can be seen that the voltage-current characteristic is such that the current increases with applied voltage, except in the Coulomb Blockade region $-V_c < V < V_c$ where no current flows. The width of the Coulomb Blockade region can be controlled by the voltage applied to the side gate 8. This is illustrated schematically by the two curves for gate voltages $V_{sga}$ and $V_{sgb}$, which respectively give rise to Coulomb Blockade regions of $2V_{cl}$ and $2V_{ch}$.

Figure 8a shows a graph of the voltage V of the memory node 2 as a function of applied gate voltage $V_g$ (in a manner corresponding to the graph of Figure 2) with the side gate voltage $V_{sg}$ set to a value which produces a relatively high Coulomb Blockade threshold $V_{ch}$, whereas Figure 8b shows a corresponding situation when the Coulomb Blockade voltage is set to a lower value $V_{cl}$.

As previously explained, a number of quantised electron states can occur at the memory node 2, which are plotted as a series of dotted lines in Figure 2, although these electron states cannot exist when the gate $V_g$ is varied in an attempt to take the memory node voltage V beyond the Coulomb Blockade limit $V_c$.

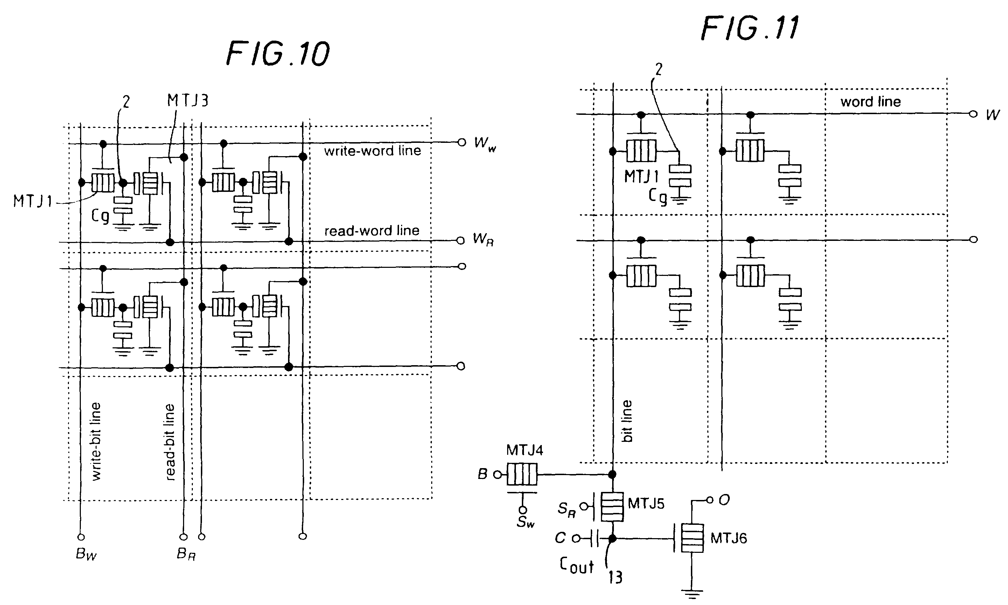

In Figure 8a and b, the characteristics for electron states at n = -2 → n= +2 are shown. In order to write information into the memory cell $M_{00}$, the write-bit line $B_W$ receives either a 0 or a 1 write pulse $B_W$ (max) or $-B_W$ (max), as shown in Figure 9. These pulses are applied to the gate capacitor $C_g$ and thus can alter the gate voltage $V_g$ between upper and lower limits $V_{gu}$, $v_{gl}$ as shown in Figure 8.

Considering now the situation shown in Figure 8a, in which the Coulomb Blockade voltage $V_c$ is set to a high value $V_{ch}$, i.e. when the write-word line $W_W$ is not enabled. In this case, if a write pulse $\pm B_W$ (max) is applied to the gate capacitor $C_g$ none of the electron states n = -2 ～ n = +2 are dragged either above or below the Coulomb Blockade limit $\pm V_{ch}$ and therefore, the electron states existing at memory node 2 remain intact for the range n = -2 ～ n = +2.

However, when the write-word line $W_W$ is enabled so that the Coulomb Blockade voltage threshold $\pm V_c$ is set to the lower limit $\pm V_{cl}$, data can be written into the memory cell, as can be seen from Figure 8b. In this case, when the write-bit line $B_W$ receives a "write 1" pulse $-B_W$ (max) the characteristics of all of the electron states that exist when $V_g = 0$, are dragged below the Coulomb Blockade threshold $- V_{cl}$, apart from the electron state n = -2. Therefore, only the electron state n = -2 can remain, which can be used to represent binary data = 1.

Similarly, when a "write 0" pulse $+B_W$ (max) is applied, the electron states which exist at $V_g = 0$ are dragged upwardly such that at $+B_W$ (max) only the electron state n = +2 can exist, because the characteristics of the other states have extended above the upper Coulomb Blockade threshold limit $V_{cl}$ and hence have been destroyed. Thus, only one electron state n = +2 remains in the cell, which can be used to represent binary 0.

Thus, binary 1 or 0 can be selectively written into the memory cell by enabling an appropriate row of the memory cells and then applying an appropriate "write 1" or "write 0" pulse to a corresponding write-bit line $B_W$. In the foregoing example, the electron states n = ±2 are used to represent binary 1 and 0. However, it will be appreciated that other electron number states could be used.

It can be shown that a suitable value of the write pulses $B_W$ can be defined as follows:

$$(V_{ch} - V_{cl})\Sigma C/C_g > B_W(\text{max}) > 2V_{cl}\Sigma C/C_g \qquad (6)$$

In order to read information from a particular memory cell, the electrometer MTJ3 for the cell needs to be enabled. Referring to Figure 6, this is achieved by concurrently applying an enabling voltage to a read-word line $W_R$ and a read-bit line $B_R$. In this way, the memory cell $M_{00}$ has its electrometer MTJ3 selectively enabled so that an output current indicative of the binary state of the memory node 2 is produced on the read-bit line $B_R$. Appropriate output circuitry (not shown) may be used in a manner known *per se* to process the output from the read-bit lines $B_R$.

Thus, in use, a particular row of the memory cell array can be selected by enabling the read-word line $W_R$ associated with the row and the state of the various cells in the row can be determined from the outputs of the individual read-bit lines $B_R$.

Another example of the memory cell is shown in Figure 10 in which like components are given the same reference numbers as in Figure 6. The connection of the memory cell is slightly different; the device MTJ1 is connected between the write-bit line $B_W$ and the memory node 2 instead of the gate capacitor $C_g$ which instead is connected to earth. The operation of the array is similar to that of Figure 6.

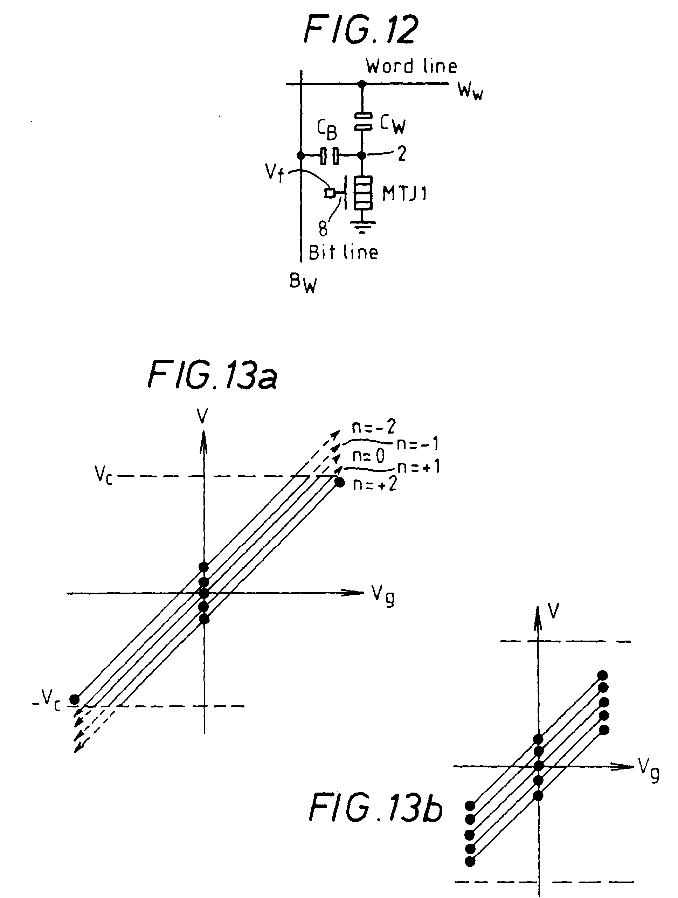

In the memory cells shown in Figure 6 and 10, an individual electrometer MTJ3 is provided in each memory cell, the electrometers being associated with read-word lines and read-bit lines $W_R$, $B_R$. However, as shown in Figure 11, it is possible to use a single electrometer with each column of the array rather than include an electrometer in each memory cell, which substantially simplifies the structure. Thus, associated with each row and column is an individual bit line B and word line W. Associated with each bit line is a sequence of side gated multiple tunnel junction devices MTJ4-6, connected as shown. In order to write information into a particular cell, a suitable word line W is enabled for the cell concerned so as to apply a suitable side gate voltage to MTJ1. Additionally, MTJ4 is opened by applying a side gate voltage $S_W$ to its side gate so that a write-bit bias B can be applied to the bit line, the bias B having a value corresponding to binary 1 or 0, so as to set the electron state of memory node 2 to define binary 1 or 0, in the manner previously described with reference to Figures 6 to 10.

In order to read information from the cell, the word line is again enabled. Additionally, a switching voltage $S_R$ is applied to the side gate of MTJ 5 to open the device and a clocking waveform C is applied to the bit line through a capacitor $C_{out}$. As a result, electrons are transferred from the memory node 2 to output node 13, depending upon the electron state of the memory node 2. The electron state of the output node 13 is connected to the side gate of MTJ6 so as to provide an output on the source/drain path thereof.

An alternative configuration for the memory cell is shown in Figure 12. Only the part of the cell necessary to achieve writing is shown and the reading arrangement, for example MTJ3 and its associated connections are omitted for the purposes of clarity. The memory cell includes the multiple tunnel junction device MTJ1, which, in this case, has its side gate 8 connected to receive a fixed voltage $V_f$ from a source not shown. The memory node 2 is connected to word-line $W_W$ and bit-line $B_W$ by respective word and bit capacitors $C_W$ and $C_B$, as shown.

Figure 13a and b illustrates a process for writing data into the memory cell. It will be appreciated that the gate voltage applied to the memory cell results from a combination of the voltages applied to the word line $W_W$ and the bit line $B_W$. When appropriate voltages are applied to both of the lines, information is written into the cell whereas if an enabling voltage is applied to only one of the line, information in the cell is not changed.

Referring to Figure 13a, this illustrates a graph of the memory node voltage V versus the gate voltage $V_g$. The upper and lower Coulomb Blockade limit voltages $V_c$ are shown by dotted lines. It will be appreciated that $V_c$ is fixed for this memory cell due to the fixed gate voltage $V_f$ applied to gate 8. Thus, at zero gate voltage, a number of stable electron states +n ~ -n can occur at the memory node 2, for which the states 1 ~ n represent binary code 1 whereas states 1~ -n represent binary 0. In Figure 13, |n|=2, by way of example. In Figure 13a, when information is written into the cell, an enabling voltage is applied to both the word line $W_W$ and the bit line $B_W$, which results in a relatively large negative going gate voltage $V_g$ given as follows: $V_g = C_b V_b + C_W V_W$. This relatively large gate voltage drags the characteristic of each of the electron states, apart from state -n, below the Coulomb Blockade threshold -$V_c$. Thus, only the state -n can exist and therefore binary 1 has been written into the cell. If enabling pulses of opposite sign are applied to the word line $W_W$ and the bit line $B_W$ simultaneously, the electron states that exist at $V_g = 0$ are dragged upwardly towards the upper Coulomb Blockade threshold $V_c$, such that only the electron state +n can exist, the other states having been destroyed by the operation of the Coulomb Blockade threshold. In this way binary 0 can be written into the cell. The gate voltage $V_g$ is then returned to 0 and as a result, either binary 1 or 0 has been written into the memory cell.

Referring to Figure 13b this shows the situation when only one of the word or bit lines $W_W$ or $B_W$ receive an enabling pulse. The electron states are shifted from the voltage values at $V_g = 0$ but they are not shifted either above or below the threshold voltages ± $V_c$ so that none of the electron states are destroyed and hence information is not written into the cell.

The relationship between the write voltages $V_W$ and $V_B$ that are applied to the word and bit lines to achieve the writing of data can be summarised as follows

$$C_W V_W + C_B V_B + ne \leq -\Sigma C V_c \qquad (7)$$

$$-\Sigma C\ V_c \leq C_W V_W ne \qquad (8)$$

$$-\Sigma C\ V_c \leq C_B V_B ne \qquad (9)$$

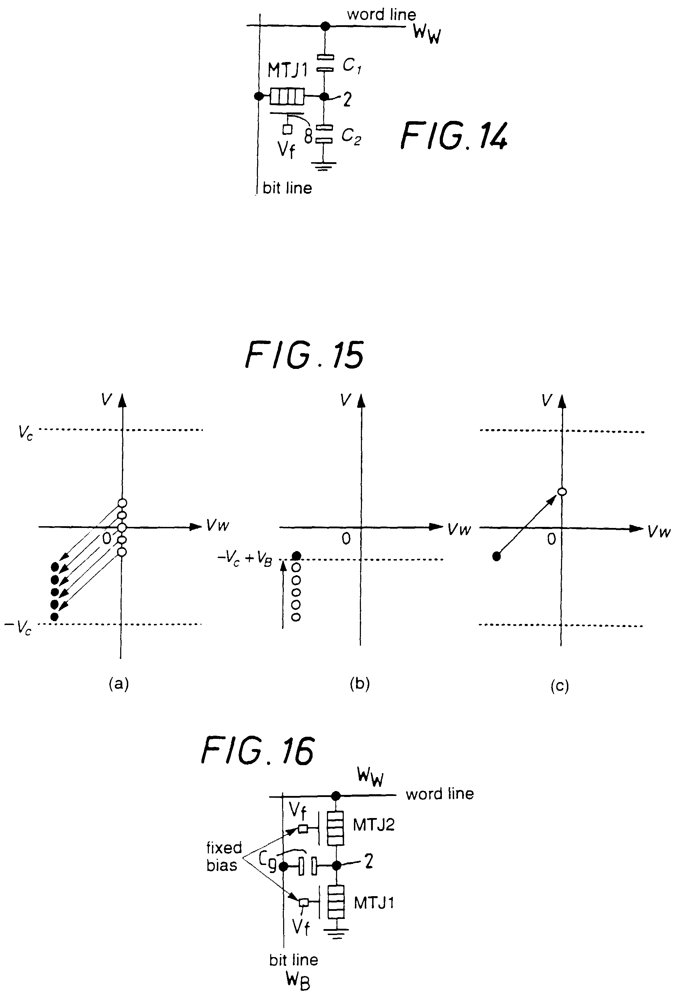

Another modification is shown in Figure 14, in which the multiple tunnel junction device MTJ1 is provided with a fixed side-gate voltage $V_f$ having its source drain path connected between the bit line $W_B$ and the memory node 2, which, in turn is connected between the word line $W_W$ and ground by series capacitors $C_1$ $C_2$ which act as gate capacitors.

The manner in which a binary 1 can be written into the memory cell of Figure 14 will now be described with reference to Figure 15. Prior to the writing process, the word and bit lines are kept at ground level and during the write process, they receive respective bias voltages $V_B$ and $V_W$ on the bit and word lines respectively. Figures 15a, b and c show successive stages in the writing process. Figure 15 illustrates the voltage V of the memory node 2 as a function of $V_W$ (which corresponds to $V_g$ of the previous Figures). In Figure 15, white circles illustrate permitted electron states before the step and black circles illustrate the electron states after the step.

Referring to Figure 15a, when a negative voltage $V_W$ is applied to the word line the electron states are shifted negatively but all of the states remain stable since they are not dragged below the lower Coulomb Blockade threshold $-V_c$. In a second step shown in Figure 15b, a positive going voltage $V_B$ is applied to the bit line $W_B$ and as a result, all of the electron states, apart the uppermost state -n, is destroyed thereby writing data into the memory cell. The word and bit lines are then returned to zero voltage as shown in Figure 15c, as a result of which only one electron state, representing binary 1 remains in the cell. It will be appreciated that by applying inverse voltages to the word and bit lines, a corresponding writing of binary 0 can be achieved so as to destroy all electron states apart from state +n.

Yet another memory cell configuration is shown in Figure 16. This includes two multi-tunnel junction devices MTJ1, MTJ2 connected in series between the word line $W_W$, the memory node 2 and ground, the gate capacitance $C_g$ being connected between the bit line $W_B$ and the memory node. Data is written into the cell in the same manner as described with reference to Figures 14 and 15.

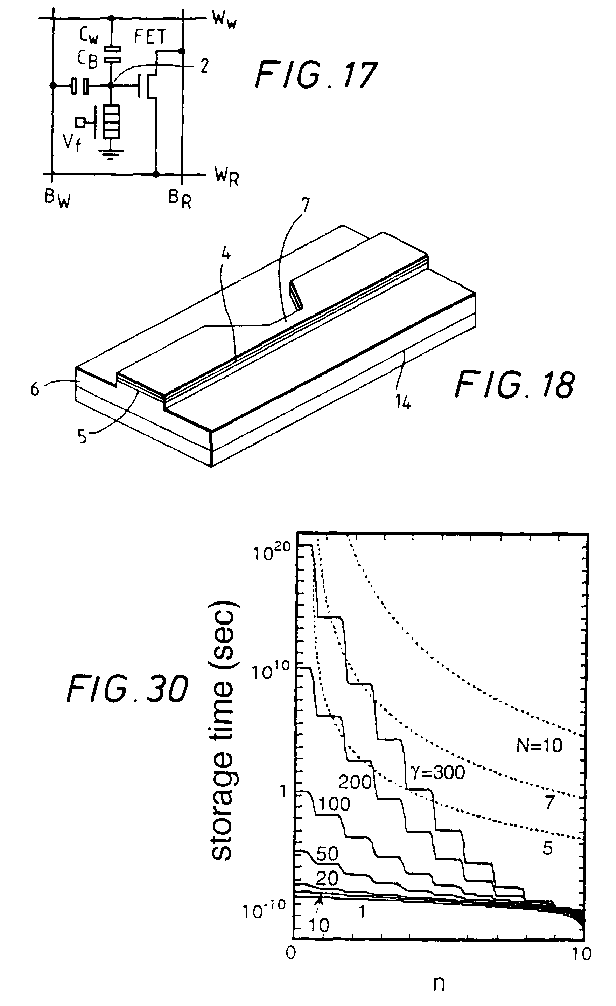

As previously stated, the arrangements for reading the cells shown in Figures 12, 14 and 16 have been omitted and it is possible to include an electrometer MTJ3 as described with reference to Figures 6 and 10 in each memory cell. As an alternative, a field effect transistor (FET) can be used to detect the electron state of the memory node 2, as shown in Figure 17, which shows a development of Figure 12 with a FET for detecting the electron state of the memory node 2.

Also, a common electrometer configuration as shown in Figure 11 can be used with any of the foregoing cells.

Considering now the physical structure of the MTJs, the previously described examples are produced by selective etching of a δ-doped layer. However many modifications and variations are possible. For example, as shown in Figure 18, the side gate for the MTJ need not necessarily be formed from a spaced portion of the δ-doped layer. Instead, it may comprise an underlying conductive layer, for example doped layer 14 shown in Figure 18.

Furthermore, the MTJ need not necessarily be constructed from a δ-doped layer as previously described. Other configurations are possible and an alternative method of producing variable-resistance tunnel junctions is to use a split-gate method with modulation-doped structures as described in Kouwenhoven, L.P., Johnson, A.T., van der Vaart, N.C., van der Enden, A., Harmans, C.J.P.M. and Foxon, C.T.,: "Quantised current in a quantum dot turnstile", Z. Phys. B - Condensed Matter, 1991, 85, pp 381-388. However, the δ-doped structure has several advantages with respect to split-gate structures. Firstly, the stray capacitance $C_s$ can be reduced because the material surrounding the memory node is etched away, resulting in reduced capacitance, which is important for the control of the multi-stability factor $\Delta$ given by equation (2). Secondly, the depletion regions become small due to the high carrier concentration in the δ-doped layer, thereby reducing the device size. Thirdly, the same process can be used, without additional steps, to make a wide range of capacitors coupled to the channel 4. Fourthly, as previously discussed, it has been found that a single constriction 7 results in the formation of several tunnel junctions, possibly because of the formation of tunnel barriers by impurities, and this is convenient for realising the memory structure and for reducing co-tunnelling effects.

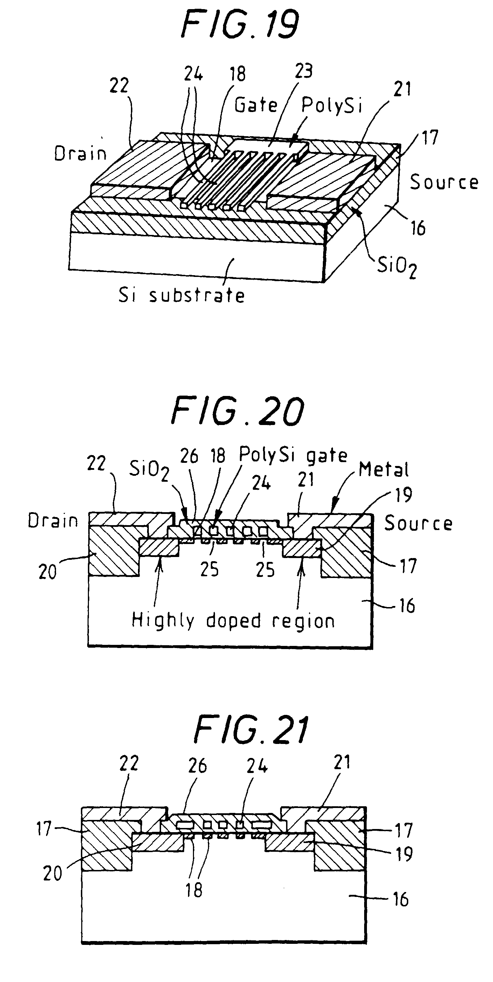

Some alternative MTJ structures will now be described. Referring to Figure 19 and 20, there is shown a silicon implemented structure which is in general terms similar to a conventional MOS transistor structure, but with an interdigitated side gate that gives rise to an MTJ structure. The device can conveniently be implemented using Si fabrication techniques although other fabrication technologies could be used. Referring to Figures 19 and 20, the MTJ comprises a Si substrate 16 with an $SiO_2$ overlayer 17 containing a conductive channel 18 that extends between highly doped source and drain regions 19, 20, provided with metallic contacts 21, 22. The channel is overlaid by a conductive polysilicon side gate 23 which includes a plurality of parallel spaced finger members or digitations 24 which may be defined by electron beam lithography and are separated from the channel by an insulating oxide region 26. In use, a voltage is applied to the gate 23 and the digitations 24 produce spaced depletion regions 25 in the channel 18. Thus, the channel includes alternating conductive and non-conductive portions between the source and drain regions 19, 20. The non-conductive depletion regions 25 constitute tunnelling barriers and it can be seen that electrically, the configuration is analogous to the multiple island arrangement shown in Figure 3a, so that the device operates as an MTJ.

In a modification shown in Figure 21, the doping profile is so arranged that conductive portions of the channel 18 are formed to underlie the polycrystaline silicon digitations 24 of the gate 23 and non conductive channel portions are provided between the digitations. Since the resulting channel comprises a sequence of conducting and non-conductive portions, the structure gives rise to multiple tunnel junctions arranged in series so as to provide the MTJ. The source, drain and channel regions may be formed by conventional lithographic techniques but the digitations 24 may be produced by electron beam lithography such that the digitations are typically of the order of 10nm in width, with equal spacing. For appropriate electron beam techniques, reference is directed to W. Chen and H. Ahmed, Fabrication of 5-7nm wide etched lines in silicon using 100keV electron beam lithography and polymethylmethacrylate resist" Appl. Phys. Lett. vol. 62, p 1499, 1993.

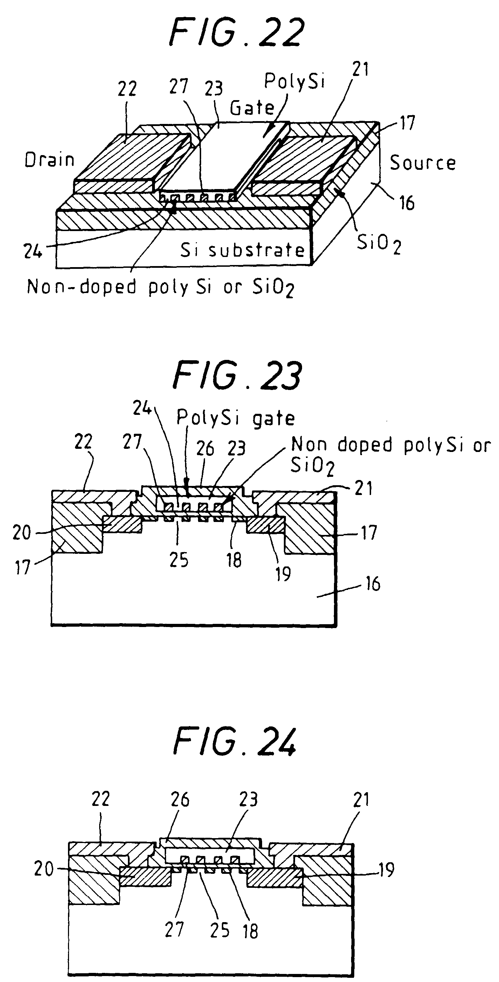

Referring now to Figures 22 and 23, this shows a modification in which the digitations are produced by firstly laying stripes of non-doped polysilicon or silicon dioxide over the channel and then forming a polysilicon gate which overlies the stripes. The effect is to spatially modulate the conductivity of the channel to provide nonconducting portions 25 thereby to produce the MTJ, as can be seen clearly in the cross section of Figure 23.

A modification to Figure 23 is shown in Figure 24 in which the dopant concentrations are so arranged that the depletion regions occur underneath the polysilicon stripes 27 rather than under the digitations 24.

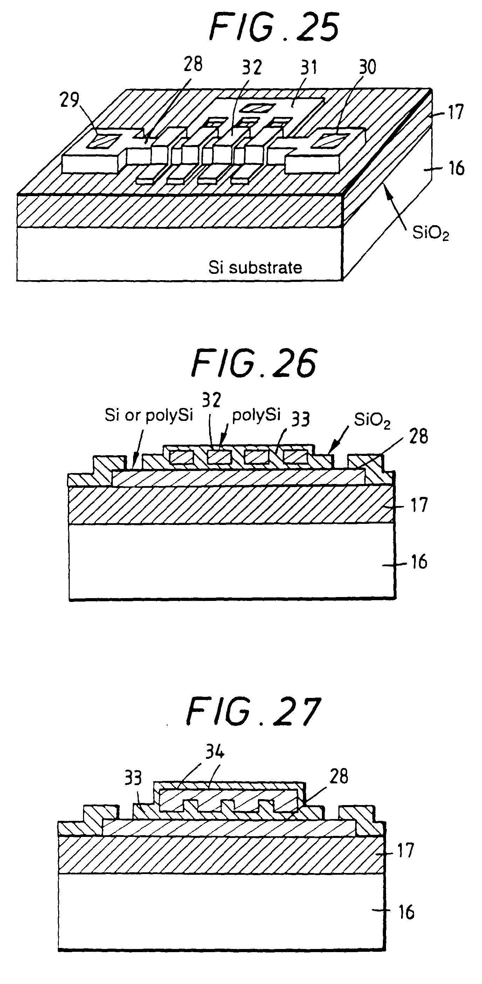

Yet another structure is shown in Figures 25 and 26, in which polysilicon or doped silicon is provided as a channel, overlying an insulating $SiO_2$ layer. This structure is resistant to soft errors produced by $\alpha$ particles creating electron-hole pairs in the semiconductor. The device consists of a silicon substrate 16 with an $SiO_2$ overlayer 17 on which is formed an overlying channel 28 of polysilicon or appropriately doped conductive silicon and provided with source and drain contacts 29, 30. A gate 31 provided with digitations 32 of polysilicon, insulated from the channel 28 by a $SiO_2$ layer 33 (Figure 26), produces a series of spaced depletion regions along the channel thereby to provide the MTJ structure. This arrangement can be seen from Figure 26 which is a section along the length of the channel.

A modification is shown in Figure 27 in which the overlying gate is provided with a ribbed configuration 34 to produce the effect provided by the digitations 32 of Figures 25 and 26.

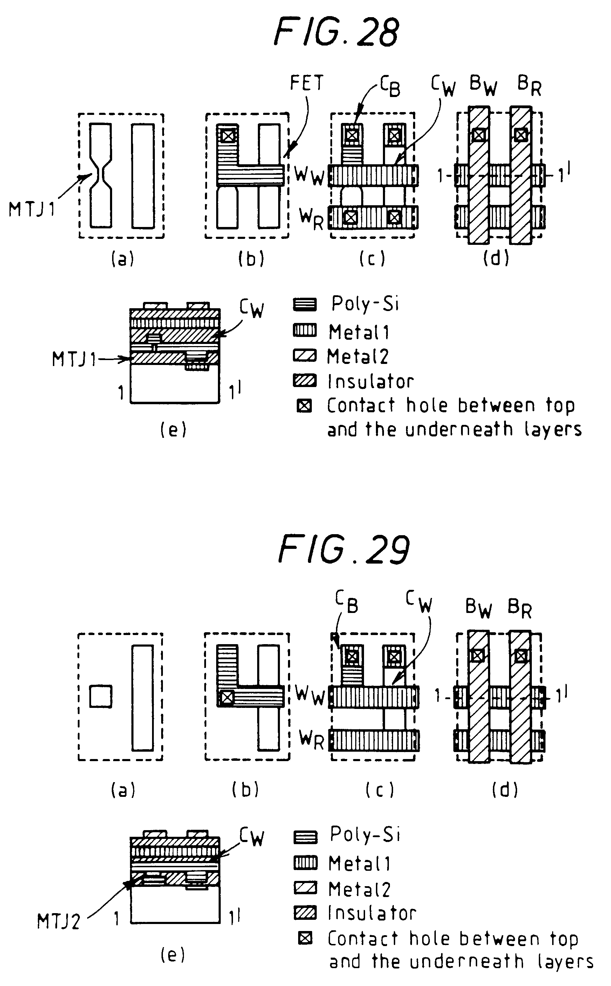

Referring now to Figure 28, this illustrates schematically a memory cell corresponding to the circuit diagram of Figure 17, constructed using Si fabrication techniques. Figures 28a-d are plan views from the bottom to the top layer of the device, which is shown in section in Figure 28e. A key to the various materials is shown in the drawings. MTJ1 is constituted by a constriction shown on the left hand side of Figures 28a. The FET is constituted by a MOS transistor on the right side of Figure 28a. Capacitors $C_W$ and $C_B$ are constituted by between the poly-Si and metal 1. The fixed voltage $V_f$ is applied to MTJ1 through the substrate. The ground level to the MTJ1 is connected to the read-word line $W_R$. The various read and write lines $W_W$, $W_R$, $B_W$ and $B_R$ are shown in the drawings.

In Figure 29, a similar configuration is shown in which the MTJ is constituted by a vertical structure. As example of a vertical multi-layered MTJ is described in GB-A-2 284 299 filed on 15th October 1993.

The required operating conditions for the MTJ will now be considered. From the experiments using the device in Figure 4, the device parameters were obtained and the storage time is presented in Figure 30 based on these parameters. In Figure 30, the solid lines show the intrinsic storage time with a parameter $\gamma$ given by $e^2/(2Ck_BT)$, where $k_B$ is the Boltzmann constant and T is the temperature. The dotted lines show co-tunnelling time, and N is the number of tunnel junctions in the MTJ. The maximum number of electrons in Coulomb Blockade region, $n_{max}$, is 10 in this case. Near $n_{max}$, storage time is relatively short, but a storage time longer than lsec is obtained when $n=n_{max}/4, \gamma \geq 200$, and $N \geq 5$. At room temperature, this condition implies that the capacitance of the MTJ should be lower than 0.02 aF, and the number of tunnel junctions in the MTJ is preferably larger than 5.

Conventional high density semiconductor memory is mainly dynamic random access memory (DRAM). However, the information in DRAM must be refreshed constantly and therefore consumes the electric power. To avoid this problem, static random access memory (SRAM) is often used instead of DRAM in mobile computers in which power consumption is one of the most key items of performance, although the memory capacity is low and the price is expensive because the memory cell structure is complicated in SRAM.

When a future DRAM with higher memory capacity is envisaged the power consumption becomes larger and in the worst case it will not operate. For current designs of DRAM cell (16 Mbit memory), the storage time t is 1 msec and information must be refreshed within this storage time. Since only one row of memory cells can be refreshed at a time, the refreshment of one cell must be finished within 250 nsec in the 16 Mbit case. If a 16 Gbit DRAM is considered, the situation becomes worse and it can be shown that the refreshment of one cell must be finished within 0.08 nsec. This is beyond the current operation speed of the peripheral circuits, for which, at present, the switching time is ~10 nsec. Even if the peripheral circuits can operate at the required speed, the power consumption will become extremely large.

In the present invention, the leakage current becomes extremely low and therefore the refreshment time can be longer than 100 sec, which has been demonstrated by the structure shown in Figure 4. This longer storage reduces the frequency of refreshment and so the power consumption can approach that of a SRAM.

**Claims**

1. A memory device including a memory cell that comprises:

   a memory node (2) for storing charge;
   barrier means for providing a tunnel barrier configuration (MTJ1) having a threshold ($\pm V_c$) for charge carrier tunnelling, in a region (7, 18) coupled to the memory node in such a manner that the memory node exhibits first and second quantised memory states ($\pm n$) for which the level of stored charge is limited by Coulomb Blockade;

characterized by a side gate (8) to produce a field in said region (7, 18) that controls the threshold of the tunnel barrier configuration therein for controlling charge carrier tunnelling through the tunnel barrier configuration to produce a transition between the quantised states at the memory node.

2. A device according to claim 1 including capacitor means ($C_g$) coupled to the memory node, and means for applying a variable voltage ($V_g$) across the capacitor means, for controlling the probability of charge tunnelling through the barrier means to produce said transition between quantised states at the node.

3. A device according to claim 1 or 2 including means ($V_{sg}$) for varying the field produced by the side gate (8), for controlling the probability of charge tunnelling through the barrier means to produce said transition between quantised states at the node.

4. A device according to any preceding claim including means for providing a further tunnel barrier configuration (MTJ2) coupled to the memory node.

5. A device according to claim 4 including a further side gate ($8_2$) for producing a field that controls said further tunnel barrier configuration.

6. A device according to any preceding claim including output means (MTJ3) for providing a logical output signal in response to the memory state of the memory node.

7. A device according to claim 6 wherein the output means comprises an electrometer (MTJ3).

8. A device including a plurality of the memory cells ($M_{mn}$) each as specified in claim 1.

9. A device according to claim 8 wherein the memory cells are arranged in rows and columns, with a plurality of row and column address lines ($W_W, B_W$) associated with the rows and columns respectively, at least one said cell including a side gated multiple tunnel junction device (MTJ1) to provide said tunnel barrier configuration and said side gate, said side gated multiple tunnel junction device (MTJ1) having a source-drain path coupled to the memory node (2), the cell being responsive to control potentials on the row and column address lines for individually switching the memory node (2) of the cell between said first and second states.

10. A device according to claim 9 wherein a gate capacitor ($C_g$) is coupled between the memory node (2) and one of the column address lines ($B_W$) and the side gate (8) is coupled to one of the row address lines ($W_W$) (Figure 6).

11. A device according to claim 9 wherein the source-drain path is coupled between the memory node (2) and one of the column address lines ($B_W$), and the side gate (8) is coupled to one of the row address lines ($W_W$) (Figure 10, 11).

12. A device according to claim 9 wherein the side gate (8) is coupled to a fixed voltage source ($V_f$), a first gate capacitor ($C_B$) is coupled between the memory node (2) and one of the column address lines ($B_W$), and a second gate capacitor ($C_W$) is coupled between the memory node (2) and one of the row address lines ($W_W$) (Figure 12).

13. A device according to claim 9 wherein the source-drain path is coupled between the memory node (2) and one of the column address lines ($B_W$), the side gate is coupled to a fixed voltage source ($V_f$), and a gate capacitor ($C_1$) is coupled between the memory node and one of the row address lines ($W_W$) (Figure 14).

14. A device according to claim 9 wherein the cell includes a further side gated multiple tunnel junction device (MTJ2) with its source-drain path coupled to the memory node (2), the side gates of both multiple tunnel junction devices being coupled to a fixed voltage source ($V_f$), the source-drain path of one of the side gated multiple tunnel junction devices (MTJ2) being coupled to one of the row address lines ($W_W$), and a gate capacitor ($C_g$) being coupled between the memory node (2) and one of the column address lines ($W_B$) (Figure 16).

15. A device according to any one of claims 9 to 14 including an output means (MTJ3,FET) within each of the cells for providing a logical output signal in response to the memory state of the cells respectively (Figure 6, 17).

16. A device according to claim 15 wherein each said output means comprises a device with a source-drain path and a gate coupled to the memory node, the array including column and row reading lines ($W_R, B_R$), the source-drain path of the output means being coupled between the column and row reading lines associated with the cell.

17. A device according to claim 16 wherein the output means comprises a side gated multiple tunnel junction device (MTJ3) whereby the source-drain current ($I_{ed}$) thereof is modulated in dependence upon the memory state of the memory node (Figure 6,

**18.** A device according to claim 16 wherein the output means comprises a FET (Figure 17).

**19.** A device according to claim 16, 17 or 18 including means for applying selective reading address signals to the reading lines to address the cells individually.

**20.** A device according to any preceding claim wherein the or each tunnel barrier configuration includes a conductive channel (4) that has been formed by selective etching and lithography from a delta doped layer in a substrate, the channel including a region of constricted width (7) which exhibits the characteristics of a multiple tunnel barrier configuration.

**21.** A device according to claim 20 wherein the side gate (8) is adjacent the constricted region.

**22.** A device according to claim 21 wherein the side gate (8) comprises a portion of the delta doped layer spaced from the channel.

**23.** A device according to claim 21 wherein the side gate comprises a further conductive layer (14) within the substrate (Figure 18).

**24.** A device according to any one of claims 1 to 19 wherein the or each tunnel barrier configuration comprises a source (21), a drain (22), a channel (18) extending from the source to the drain, and wherein the side gate (23) includes a plurality of gate regions (24) which induce spaced depletion regions (25) in the channel (Figure 19).

**25.** A device according to claim 24 wherein the gate regions comprise spaced digitations (24).

**26.** A device according to claim 24 wherein the gate regions comprise spaced gate thickness modulations.

**27.** A memory device including a memory cell that comprises:

a memory node (2) for storing charge;
means for providing a multiple tunnel barrier configuration (MTJ1) for charge carriers, coupled to the memory node, in such a manner that the node exhibits first and second quantised memory states ($\pm$n), with the voltage level at the node being limited by Coulomb Blockade to a threshold voltage ($\pm V_C$) ; and
control means for controlling charge carrier tunnelling through the multiple tunnel barrier configuration to produce a transition between the quantised states at the node, **characterised in that** the control means includes first and second means ($W_W$, $W_B$) for selectively applying respective control potentials to the node of the cell, the node being switched between said first and second quantized states in response to predetermined combinations of said control potentials (Figure 12).

**28.** A device according to claim 27 wherein the means for providing the multiple tunnel barrier configuration includes a side gate (8).

**Patentansprüche**

**1.** Speichervorrichtung mit einer Speicherzelle, die folgendes enthält:

einen Speicherknoten (2) zum Speichern von Ladung,
eine Barriereneinrichtung zur Erzeugung einer Tunnelbarrierenanordnung (MTJ1), die einen Schwellenwert ($\pm V_c$) für Ladungsträgertunneln hat, in einem Bereich (7, 18), der mit dem Speicherknoten verbunden ist, derart, daß der Speicherknoten erste und zweite quantisierte Speicherzustände ($\pm$n) zeigt, für die der Pegel von gespeicherter Ladung durch Coulomb-Blockade beschränkt wird,

gekennzeichnet durch ein Seiten-Gate (8), um ein Feld in dem Bereich (7, 18) zu erzeugen, das den Schwellenwert der Tunnelbarrierenanordnung darin steuert, zur Steuerung des Ladungsträgertunnelns durch die Tunnelbarrierenanordnung, um einen Übergang zwischen den quantisierten Zuständen am Speicherknoten zu erzeugen.

**2.** Vorrichtung nach Anspruch 1, mit einer Kondensatoreinrichtung ($C_g$), die mit dem Speicherknoten verbunden ist, und mit einer Einrichtung zum Anlegen einer veränderlichen Spannung ($V_g$) quer über die Kondensatoreinrichtung, zur Steuerung der Wahrscheinlichkeit von Ladungsträgertunneln durch die Barriereneinrichtung, um den Übergang zwischen quantisierten Zuständen an dem Knoten zu erzeugen.

**3.** Vorrichtung nach Anspruch 1 oder 2, mit einer Einrichtung ($V_{sg}$) zum Verändern des vom Seiten-Gate (8) erzeugten Feldes, zur Steuerung der Wahrscheinlichkeit von Ladungsträgertunneln durch die Barriereneinrichtung, um den Übergang zwischen quantisierten Zuständen an dem Knoten zu erzeugen.

**4.** Vorrichtung nach einem der vorhergehenden Ansprüche, mit einer Einrichtung zur Erzeugung einer weiteren Tunnelbarrierenanordnung (MTJ2), die mit dem Speicherknoten verbunden ist.

5. Vorrichtung nach Anspruch 4, mit einem weiteren Seiten-Gate ($8_2$) zur Erzeugung eines Feldes, das die weitere Tunnelbarrierenanordnung steuert.

6. Vorrichtung nach einem der vorhergehenden Ansprüche, mit einer Ausgabeeinrichtung (MTJ3) zur Erzeugung eines logischen Ausgangssignals als Antwort auf den Speicherzustand des Speicherknotens.

7. Vorrichtung nach Anspruch 6, bei der die Ausgabeeinrichtung ein Elektrometer (MTJ3) enthält.

8. Vorrichtung mit einer Vielzahl von Speicherzellen ($M_{mn}$) jeweils wie in Anspruch 1 spezifiziert.

9. Vorrichtung nach Anspruch 8, bei der die Speicherzellen in Reihen und Spalten angeordnet sind, mit einer Vielzahl von Reihen- und Spalten-Adreßleitungen ($W_W$, $B_W$), die zu den Reihen bzw. Spalten gehören, und mindestens eine Zelle eine mit Seiten-Gate versehene Mehrfach-Tunnelübergangsvorrichtung (MTJ1) aufweist, um die Tunnelbarrierenanordnung und das Seiten-Gate zu erzeugen, wobei die mit Seiten-Gate versehene Mehrfach-Tunnelübergangsvorrichtung (MTJ1) eine mit dem Speicherknoten (2) verbundene Source-Drain-Strecke enthält und wobei die Zelle auf Steuerpotentiale auf den Reihen- und Spalten-Adreßleitungen reagiert, um den Speicherknoten (2) der Zelle individuell zwischen den ersten und zweiten Zuständen umzuschalten.

10. Vorrichtung nach Anspruch 9, bei der ein Gate-Kondensator ($C_g$) zwischen dem Speicherknoten (2) und einer der Spalten-Adreßleitungen ($B_W$) verbunden ist und das Seiten-Gate (8) mit einer der Reihen-Adreßleitungen ($W_W$) verbunden ist (Figur 6).

11. Vorrichtung nach Anspruch 9, bei der die Source-Drain-Strecke zwischen dem Speicherknoten (2) und einer der Spalten-Adreßleitungen ($B_W$) verbunden ist und das Seiten-Gate (8) mit einer der Reihen-Adreßleitungen ($W_W$) verbunden ist (Figur 10, 11).

12. Vorrichtung nach Anspruch 9, bei der das Seiten-Gate (8) mit einer Festspannungsquelle (V,) verbunden ist, ein erster Gate-Kondensator ($C_B$) zwischen dem Speicherknoten (2) und einer der Spalten-Adreßleitungen ($B_W$) verbunden ist und ein zweiter Gate-Kondensator ($C_W$) zwischen dem Speicherknoten (2) und einer der Reihen-Adreßleitungen ($W_W$) verbunden ist (Figur 12).

13. Vorrichtung nach Anspruch 9, bei der die Source-Drain-Strecke zwischen dem Speicherknoten (2) und einer der Spalten-Adreßleitungen ($B_W$) verbunden ist, das Seiten-Gate (8) mit einer Festspannungsquelle ($V_f$) verbunden ist und ein Gate-Kondensator ($C_1$) zwischen dem Speicherknoten und einer der Reihen-Adreßleitungen ($W_W$) verbunden ist (Figur 14).

14. Vorrichtung nach Anspruch 9, bei der die Zelle eine weitere mit Seiten-Gate versehene Mehrfach-Tunnelübergangsvorrichtung (MTJ2) enthält, deren Source-Drain-Strecke mit dem Speicherknoten (2) verbunden ist, wobei die Seiten-Gates beider Mehrfach-Tunnelübergangsvorrichtungen mit einer Festspannungsquelle ($V_f$) verbunden sind, die Source-Drain-Strecke einer der mit Seiten-Gate versehenen Mehrfach-Tunnelübergangsvorrichtungen (MTJ2) mit einer der Reihen-Adreßleitungen ($W_W$) verbunden ist und ein Gate-Kondensator ($C_g$) zwischen dem Speicherknoten (2) und einer der Spalten-Adreßleitungen ($W_B$) verbunden ist (Figur 16).

15. Vorrichtung nach einem der Ansprüche 9 bis 14, mit einer Ausgabeeinrichtung (MTJ3, FET) innerhalb jeder der Zellen, zur Erzeugung eines logischen Ausgangssignals als Antwort auf den Speicherzustand der jeweiligen Zellen (Figur 6, 17).

16. Vorrichtung nach Anspruch 15, bei der die Ausgabeeinrichtung eine Vorrichtung mit einer Source-Drain-Strecke und einem mit dem Speicherknoten verbundenen Gate enthält, die Matrix Spalten- und Reihen-Leseleitungen ($W_R$, $B_R$) enthält und die Source-Drain-Strecke der Ausgabeeinrichtung zwischen zu der Zelle gehörenden Spalten- und Reihen-Leseleitungen verbunden ist.

17. Vorrichtung nach Anspruch 16, bei der die Ausgabeeinrichtung eine mit Seiten-Gate versehene Mehrfach-Tunnelübergangsvorrichtung (MTJ3) enthält, wodurch ihr Source-Drain-Strom ($I_{ed}$) in Abhängigkeit vom Speicherzustand des Speicherknotens moduliert wird (Figur 6, 10).

18. Vorrichtung nach Anspruch 16, bei der die Ausgabeeinrichtung einen FET aufweist (Figur 17).

19. Vorrichtung gemäß Anspruch 16, 17 oder 18, mit einer Einrichtung zum Anlegen von selektiven Lese-Adreßsignalen an die Leseleitungen, um die Zellen individuell zu adressieren.

20. Vorrichtung nach einem der vorhergehenden Ansprüche, bei der die oder jede Tunnelbarrierenanordnung einen leitfähigen Kanal (4) enthält, der durch selektives Ätzen und Lithographie aus einer deltadotierten Schicht in einem Substrat gebildet worden ist, wobei der Kanal einen Bereich mit eingeengter Breite (7) enthält, der die Eigenschaften einer Mehrfach-Tunnelbarrierenanordnung zeigt.

21. Vorrichtung nach Anspruch 20, bei der das Seiten-Gate (8) an den eingeengten Bereich angrenzt.

22. Vorrichtung nach Anspruch 21, bei der das Seiten-Gate (8) einen im Abstand vom Kanal angeordneten Teil der deltadotierten Schicht enthält.

23. Vorrichtung nach Anspruch 21, bei der das Seiten-Gate eine weitere leitfähige Schicht (14) innerhalb des Substrats enthält (Figur 18).

24. Vorrichtung nach einem der Ansprüche 1 bis 19, bei der die oder jede Tunnelbarrierenanordnung eine Source (21), einen Drain (22) und einen Kanal (18) enthält, der sich von der Source zum Drain erstreckt, und bei der das Seiten-Gate (23) eine Vielzahl von Gate-Bereichen (24) enthält, die im Abstand angeordnete Verarmungsbereiche (25) im Kanal induzieren (Figur 19).

25. Vorrichtung nach Anspruch 24, bei der die Gate-Bereiche im Abstand angeordnete Finger (24) enthalten.

26. Vorrichtung nach Anspruch 24, bei der die Gate-Bereiche im Abstand angeordnete Dickemodulationen enthalten.

27. Speichervorrichtung mit einer Speicherzelle, die folgendes enthält:

einen Speicherknoten (2) zum Speichern von Ladung,
eine Einrichtung zur Erzeugung einer Mehrfach-Tunnelbarrierenanordnung (MTJ1) für Ladungsträger, die mit dem Speicherknoten verbunden ist, derart, daß der Knoten erste und zweite quantisierte Speicherzustände (±n) zeigt, wobei der Spannungspegel an dem Knoten durch Coulomb-Blockade auf einen Schwellenwert (±$V_c$) beschränkt wird, und
einer Steuereinrichtung zur Steuerung von Ladungsträgertunneln durch die Mehrfach-Tunnelbarrierenanordnung, um einen Übergang zwischen den quantisierten Zuständen an dem Knoten zu erzeugen, **dadurch gekennzeichnet, daß** die Steuereinrichtung eine erste und eine zweite Einrichtung ($W_W$, $W_B$) zum selektiven Anlegen von Steuerpotentialen an den Knoten der Zelle aufweist, wobei der Knoten als Antwort auf vorbestimmte Kombinationen der Steuerpotentiale zwischen den ersten und zweiten quantisierten Zuständen umgeschaltet wird (Figur 12).

28. Vorrichtung nach Anspruch 27, bei der die Einrichtung zur Erzeugung der Mehrfach-Tunnelbarrierenanordnung ein Seiten-Gate (8) enthält.

**Revendications**

1. Dispositif à mémoire comprenant une cellule de mémoire qui comporte :

un noeud (2) de mémoire destiné au stockage d'une charge ;
un moyen à barrière destiné à présenter une configuration (MTJ1) de barrière à effet tunnel ayant un seuil (±$V_c$) pour le passage par effet tunnel d'un porteur de charge, dans une région (7, 18) couplée au noeud de mémoire d'une manière telle que le noeud de mémoire présente des premier et second états de mémoire quantifiés (±n) pour lesquels le niveau de la charge stockée est limité par le blocage de Coulomb ("Coulomb Blockade") ;

caractérisé par une grille latérale (8) destinée à produire un champ dans ladite région (7, 18) qui y règle le seuil de la configuration de la barrière à effet tunnel pour commander le passage par effet tunnel de porteurs de charge à travers la configuration de barrière à effet tunnel afin de produire une transition entre les états quantifiés au noeud de mémoire.

2. Dispositif selon la revendication 1, comprenant un moyen à condensateur ($C_g$) couplé au noeud de mémoire, et un moyen destiné à appliquer une tension variable ($V_g$) aux bornes du moyen à condensateur, afin de commander la probabilité de passage par effet tunnel d'une charge à travers le moyen à barrière pour produire ladite transition entre des états quantifiés au noeud.

3. Dispositif selon la revendication 1 ou 2, comprenant un moyen ($V_{sg}$) destiné à faire varier le champ produit par la grille latérale (8), afin de commander la probabilité de passage par effet tunnel d'une charge à travers le moyen à barrière pour produire ladite transition entre des états quantifiés au noeud.

4. Dispositif selon l'une quelconque des revendications précédentes, comprenant un moyen destiné à procurer une autre configuration (MTJ2) de barrière à effet tunnel couplée au noeud de mémoire.

5. Dispositif selon la revendication 4, comprenant une autre grille latérale ($8_2$) destinée à produire un champ qui commande ladite autre configuration de

**barrière à effet tunnel.**

**6.** Dispositif selon l'une quelconque des revendications précédentes, comprenant un moyen de sortie (MTJ3) destiné à produire un signal de sortie logique en réponse à l'état de mémoire du noeud de mémoire.

**7.** Dispositif selon la revendication 6, dans lequel le moyen de sortie comprend un électromètre (MTJ3).

**8.** Dispositif comprenant une pluralité de cellules de mémoire ($M_{mn}$) chacune telle que spécifiée dans la revendication 1.

**9.** Dispositif selon la revendication 8, dans lequel les cellules de mémoire sont agencées en rangées et colonnes, avec une pluralité de lignes d'adresses ($W_W$, $B_W$) de rangées et de colonnes associées aux rangées et colonnes respectivement, au moins l'une desdites cellules comprenant un dispositif (MTJ1) à jonction à effet tunnel, multiple, à grille latérale pour procurer ladite configuration de barrière à effet tunnel et ladite grille latérale, ledit dispositif (MTJ1) de jonction à effet tunnel multiple à grille latérale ayant un chemin source-drain couplé au noeud (2) de mémoire, la cellule réagissant à des potentiels de commande sur les lignes d'adresses de rangées et de colonnes pour connecter individuellement le noeud (2) de mémoire de la cellule entre lesdits premier et second états.

**10.** Dispositif selon la revendication 9, dans lequel un condensateur ($C_g$) de grille est couplé entre le noeud (2) de mémoire et l'une des lignes d'adresses ($B_w$) de colonnes et la grille latérale (8) est couplée à l'une des lignes ($W_W$) d'adresses de rangées (figure 6).

**11.** Dispositif selon la revendication 9, dans lequel le trajet source-drain est couplé entre le noeud (2) de mémoire et l'une des lignes d'adresses ($B_W$) de colonnes, et la grille latérale (8) est couplée à l'une des lignes d'adresses ($W_W$) de rangées (figures 10, 11).

**12.** Dispositif selon la revendication 9, dans lequel la grille latérale (8) est couplée à une source de tension fixe ($V_f$), un premier condensateur ($C_B$) de grille est couplé entre le noeud (2) de mémoire et l'une des lignes ($B_W$) d'adresses de colonnes, et un second condensateur ($C_W$) de grille est couplé entre le noeud (2) de mémoire et l'une des lignes d'adresses ($W_W$) de rangées (figure 12).

**13.** Dispositif selon la revendication 9, dans lequel le trajet source-drain est couplé entre le noeud (2) de mémoire et l'une des lignes ($B_W$) d'adresses de colonnes, la grille latérale est couplée à une source de tension fixe ($V_f$) et un condensateur ($C_1$) de grille est couplé entre le noeud (2) de mémoire et l'une des lignes ($W_W$) d'adresses de rangées (figure 14).

**14.** Dispositif selon la revendication 9, dans lequel la cellule comprend un autre dispositif (MTJ2) à jonctions à effet tunnel multiples, à grille latérale, dont le trajet source-drain est couplé au noeud (2) de mémoire, les grilles latérales des deux dispositifs à jonctions à effet tunnel multiples étant couplées à une source de tension fixe ($V_f$), le trajet source-drain de l'un des dispositifs (MTJ2) à jonctions à effet tunnel multiples à grilles latérales étant couplé à l'une des lignes ($W_W$) d'adresses de rangées, et un condensateur ($C_g$) de grille étant couplé entre le noeud (2) de mémoire et l'une des lignes ($W_W$) d'adresses de colonnes (figure 16).

**15.** Dispositif selon l'une quelconque des revendications 9 à 14, comprenant un moyen de sortie (MTJ3, FET) à l'intérieur de chacune des cellules pour produire un signal de sortie logique en réponse à l'état de mémoire des cellules, respectivement (figures 6, 17).

**16.** Dispositif selon la revendication 15, dans lequel chacun desdits moyens de sortie comporte un dispositif ayant un trajet source-drain et une grille couplée au noeud de mémoire, le réseau comprenant des lignes ($W_R$, $B_R$) de lecture de colonnes et de rangées, le trajet source-drain des moyens de sortie étant couplé entre les lignes de lecture de colonnes et de rangées associées à la cellule.

**17.** Dispositif selon la revendication 16, dans lequel les moyens de sortie comprennent un dispositif (MTJ3) à jonctions à effet tunnel multiples, à grille latérale, dont le courant source-drain ($I_{ed}$) est modulé en fonction de l'état de mémoire du noeud de mémoire (figures 6, 10).

**18.** Dispositif selon la revendication 16, dans lequel le moyen de sortie comprend un transistor à effet de champ FET (figure 17).

**19.** Dispositif selon la revendication 16, 17 ou 18, comprenant des moyens destinés à appliquer des signaux d'adresse de lecture sélectifs aux lignes de lecture pour l'adressage individuel des cellules.

**20.** Dispositif selon l'une quelconque des revendications précédentes, dans lequel la ou chaque configuration de barrière à effet tunnel comprend un canal conducteur (4) qui a été formé par attaque chimique sélective et lithographie à partir d'une couche à dopage delta dans un substrat, le canal comprenant une région de largeur resserrée (7) qui présente les caractéristiques d'une configuration de barrière à effet tunnel multiple.

21. Dispositif selon la revendication 20, dans lequel la grille latérale (8) est adjacente à la région resserrée.

22. Dispositif selon la revendication 21, dans lequel la grille latérale (8) comprend une partie de la couche à dopage delta espacée du canal.

23. Dispositif selon la revendication 21, dans lequel la grille latérale comporte une autre couche conductrice (14) à l'intérieur du substrat (figure 18).

24. Dispositif selon l'une quelconque des revendications 1 à 19, dans lequel la ou chaque configuration de barrière à effet tunnel comprend une source (21), un drain (22), un canal (18) s'étendant depuis la source jusqu'au drain, et dans lequel la grille latérale (23) comprend une pluralité de régions (24) de grille qui induisent des régions espacées (25) d'appauvrissement dans le canal (figure 19).

25. Dispositif selon la revendication 24, dans lequel les régions de grille comprennent des digitations espacées (24).

26. Dispositif selon la revendication 24, dans lequel les régions de grille comprennent des modulations d'épaisseur des grilles espacées.

27. Dispositif à mémoire comprenant une cellule de mémoire qui comporte :

un noeud (2) de mémoire destiné à stocker une charge ;
des moyens destinés à procurer une configuration (MTJ1) de barrière à effet tunnel multiple pour des porteurs de charges, couplés au noeud de mémoire, d'une manière telle que le noeud présente des premier et second états de mémoire quantifiés ($\pm n$), le niveau de tension au noeud étant limité par le blocage de Coulomb à une tension de seuil ($\pm V_c$) ; et
des moyens de commande destinés à commander le passage par effet tunnel de porteurs de charges à travers la configuration de barrière à effet tunnel multiple afin de produire une transition entre les états quantifiés au noeud, caractérisé en ce que les moyens de commande comprennent des premier et second moyens ($W_W$, $W_B$) destinés à appliquer sélectivement des potentiels de commande respectifs au noeud de la cellule, le noeud étant commuté entre lesdits premier et second états quantifiés en réponse à des combinaisons prédéterminées desdits potentiels de commande (figure 12).

28. Dispositif selon la revendication 27, dans lequel les moyens destinés à procurer la configuration de barrière à effet tunnel multiple comprennent une grille latérale (8).

## *FIG.1*

## *FIG.2*

30μm

# FIG. 4

Vg
9
4a
8₂
7₂
MTJ 2
Cg
4b
2
8₁
11
10
7₁
MTJ 1
4
7₃
Ved
12
MTJ 3
Veg

# FIG. 5

Current through electrometer $I_{ed}$

T = 30 mk
3 scans between 0.5V & −0.5V

T = 30 mk
1 scan between 0.25V & −0.25V

Write '1'          Write '0'

'1'

'0'

−1          0          1 −1          0          1

Gate voltage Vg          Gate voltage Vg

*FIG.3*

*FIG.3a*

insulating GaAs substrate

MTJ

electric field

side gate

# FIG. 6

# FIG. 9

write '0'          write '1'

FIG.7a

FIG.7b

FIG.8a

FIG.8b

FIG.11

FIG.10

## FIG.12

Word line

$W_W$

$C_B$  $C_W$

$V_f$  2

8  MTJ1

Bit line

$B_W$

## FIG.13a

V

$V_c$

n=-2
n=-1
n=0
n=+1
n=+2

$V_g$

$-V_c$

## FIG.13b

V

$V_g$

*FIG.14*

*FIG.15*

(a)  (b)  (c)

*FIG.16*

FIG.17

FIG.18

FIG.30

storage time (sec)

## FIG.19

## FIG.20

## FIG.21

# FIG. 22

# FIG. 23

# FIG. 24

## FIG.25

## FIG.26

## FIG.27

## FIG. 28

(a)  (b)  (c)  (d)

(e)

- Poly-Si
- Metal1
- Metal2
- Insulator
- ⊠ Contact hole between top and the underneath layers

## FIG. 29

(a)  (b)  (c)  (d)

(e)

- Poly-Si
- Metal1
- Metal2
- Insulator
- ⊠ Contact hole between top and the underneath layers